# EUROPÄISCHE PATENTSCHRIFT

(11) **EP 1 515 443 B1**
(45) Veröffentlichungstag und Bekanntmachung des Hinweises auf die Patenterteilung: **05.07.2006**
(21) Anmeldenummer: 03292213.0
(22) Anmeldetag: 09.09.2003
(51) Int. Cl.: H03L 7/08, H03K 3/011, H03J 7/04

(54) **Frequenzstabilisierung eines als niederfrequenter Taktgeber in Mobilfunkgeräten verwendeten stromgesteuerten Oszillatorschaltkreises**
Frequency stabilisation of a current controlled oscillator used as a low frequency clock generator in a portable radio device
Stabilisation de fréquence d'un oscillateur commandé en courant appliqué comme horloge basse fréquence dans un radiotéléphone mobile

(43) Veröffentlichungstag der Anmeldung: 16.03.2005
(73) Patentinhaber: Infineon Technologies AG, 81669 München (DE)
(72) Erfinder: Labarre, Eric, Bat. Cyclamens 06800 Cagnes/mer (FR); Bonnardot, André, 06560 Valbonne (FR); Ribas, Raymond, 06400 Cannes (FR); Arriordaz, Alexandre, 06160 Juan-Les-Pins (FR)
(74) Vertreter: Graf Lambsdorff, Matthias

(56) Entgegenhaltungen:
- DE-A- 10 029 421
- US-A- 4 450 518
- US-A- 5 543 754
- US-A- 5 859 560
- US-A- 6 100 766

## Beschreibung

Die Erfindung betrifft eine Vorrichtung und ein Verfahren zur Frequenzstabilisierung eines stromgesteuerten Oszillatorschaltkreises nach den unabhängigen Patentansprüchen und darauf basierend eine Vorrichtung und ein Verfahren zur Erzeugung eines frequenzstabilisierten Zeittaktes und einen eine solche Vorrichtung enthaltenden Halbleiter-Chip.

In elektronischen Geräten wird häufig ein Zeittakt benötigt, der verschiedensten Anforderungen genügen muss. In Geräten mit Funkschnittstelle beispielsweise unterscheiden sich die Anforderungen an die Genauigkeit während der Datenübertragung deutlich von der Anforderung im Stand-by-Betrieb. Während der Datenübertragung müssen Sende- und Empfangsgeräte ihre Zeittakte synchronisieren, z.B. zum korrekten Positionieren von Zeitfenstern bei TDMA-Verfahren. Im Stand-by-Betrieb wird der Zeittakt beispielsweise zum Betrieb einer Echtzeituhr verwendet. In mobilen, netzunabhängigen Geräten soll zudem die Leistungsaufnahme des Taktgebers gering sein, was vor Allem während des Stand-by-Betriebs wichtig ist.

Geräte mit Funkschnittstelle weisen daher typischerweise zwei Taktgeber auf. Ein hochfrequenter Quarzoszillator liefert einen hochgenauen Zeittakt für die Datenübertragung. Ein niederfrequenter Oszillator liefert einen Zeittakt mit geringerer Genauigkeit und geringerer Leistungsaufnahme.

Der niederfrequente Oszillator kann beispielsweise als externes Bauelement in Form eines zweiten Quarzoszillators aufgebaut werden. Dies erhöht jedoch die Anzahl der verwendeten Bauelemente, was sich nachteilig auf die Bauteilkosten, den Platzbedarf und die Leistungsaufnahme der Schaltung auswirkt.

Aus der Patentschrift DE 100 29 421 C2 ist eine Vorrichtung bekannt, die den niederfrequenten Oszillator auf einem Halbleiter-Chip integriert. Nachteilig an einer derartigen Lösung ist die stark verminderte Frequenzkonstanz, wodurch häufige Kalibrierungen notwendig werden, was einen erhöhten Energieverbrauch bedingt. In einer Variante der in dieser Patentschrift beschriebenen Erfindung ist der niederfrequente integrierte Oszillator als durchstimmbarer, stromgesteuerter Oszillatorschaltkreis aufgebaut. In dieser Patentschrift wird jedoch keine konkrete Ausgestaltung der Variante beschrieben.

In der Patentschrift US 6,100,766 wird ein Frequenzkorrektur-Schaltkreis für einen stromgesteuerten Oszillator-Schaltkreis offenbart. Der Frequenzkorrektur-Schaltkreis umfasst einen Logik-Schaltkreis, welcher das Oszillatorsignal mit einem Referenzsignal vergleicht und daraus eine Steuersignal erzeugt, mit dessen Hilfe ein einstellbares Widerstandsmittel angesteuert wird, welches die Frequenz des Oszillator-Schaltkreises steuert.

Aufgabe der Erfindung ist es, eine Vorrichtung und ein Verfahren zur Frequenzstabilisierung eines stromgesteuerten Oszillatorschaltkreises anzugeben, mit welchen eine verbesserte Steuerung des Oszillatorschaltkreises realisiert werden kann.

Diese Aufgabe wird durch die Merkmale der unabhängigen Patentansprüche gelöst. Vorteilhafte Weiterbildungen und Ausgestaltungen sind in den Unteransprüchen und in nebengeordneten Patentansprüchen angegeben. Somit sind ebenso eine Vorrichtung und ein Verfahren zur Erzeugung eines frequenzstabilisierten Zeittaktes und ein eine derartige Vorrichtung enthaltender Halbleiter-Chip angegeben.

Die erfindungsgemäße Vorrichtung und das erfindungsgemäße Verfahren dienen der Frequenzstabilisierung eines stromgesteuerten Oszillatorschaltkreises, d.h. eines Oszillatorschaltkreises, dessen Frequenz über die Stärke des Steuerstroms eingestellt werden kann. Die Vorrichtung weist in an sich bekannter Weise ein Vergleichsmittel zum Vergleichen der Ausgangsfrequenz des Oszillatorschaltkreises mit der Frequenz eines Referenzsignals und ein Steuermittel zum Einstellen des Steuerstroms des Oszillatorschaltkreises auf. Innerhalb des Steuermittels ist ein Widerstandsmittel mit einstellbarem Gesamtwiderstand vorgesehen. An das Widerstandsmittel wird eine Spannung angelegt und mittels des einstellbaren Gesamtwiderstandes die Stromstärke gesteuert. Das Vergleichsmittel gibt in Abhängigkeit eines Vergleichs der Ausgangsfrequenz des zu steuernden Oszillatorschaltkreises mit der Frequenz eines Referenzsignals ein Steuersignal an das einstellbare Widerstandsmittel innerhalb des Steuermittels aus.

An das Widerstandsmittel wird eine stabilisierte Spannung angelegt, welche zum Beispiel in bekannter Weise aus einer Bandlücke abgeleitet wird. Dadurch wird ein stabilisierter Steuerstrom erzeugt, der die Frequenz des Oszillatorschaltkreises stabilisiert.

Das Vergleichsmittel besteht erfindungsgemäß aus einem Ableitungsmittel, einem Kontrollmittel, einem Einstellmittel sowie optional einem Filter. Das Ableitungsmittel leitet dabei aus dem Rückkoppelsignal des Oszillatorschaltkreises sowie aus dem Referenzsignal je ein Zwischensignal ab, wobei beide Zwischensignale eine identische Zielfrequenz besitzen. Das Kontrollmittel ermittelt anhand der Frequenzabweichung der beiden Zwischensignale ein Steuersignal, das die notwendige Frequenzänderung des Oszillatorschaltkreises beschreibt. Das Einstellmittel nimmt das Steuersignal des Kontrollmittels entgegen und setzt dieses in ein Steuersignal für das Widerstandsmittel um. Vorteilhafterweise ist dem Einstellmittel und dem Widerstandsmittel ein Filter zwischengeschaltet, das Oszillationen des Steuersignals während des beschriebenen Kalibriervorgangs unterdrückt. Das Filter kann weiterhin dazu eingesetzt werden, das Ende des Kalibriervorgangs zu bestimmen, also festzulegen, wann der Abgleich des Oszillatorschaltkreises mit dem Referenzsignal eine ausreichende Güte erreicht hat. Dies wird beispielsweise anhand einer charakteristischen Folge von Steuersignalen festgestellt.

In einer vorteilhaften Ausgestaltung der Erfindung wird das Widerstandsmittel vom Vergleichsmittel digital angesteuert. Die Ansteuerung kann über ein Bitwort der Breite N geschehen. Dadurch werden die einstellbaren Widerstandswerte des Widerstandsmittels auf 2^{N} diskrete Zustände beschränkt. Das Widerstandsmittel kann somit als Widerstandsmittel aufgebaut werden, dessen Gesamtwiderstand nur in diskreten Stufen verändert werden kann. Das Widerstandsmittel kann z.B. aus Schaltern und damit verbundenen Widerständen aufgebaut werden, wobei jeder steuerbare Schalter einem Bit des Bitwortes zugeordnet wird. Der Gesamtwiderstand des Widerstandsmittels kann somit durch Setzen der mit Schaltern verbundenen Bits des Bitwortes bestimmt werden.

Eine weitere vorteilhafte Ausgestaltung der Erfindung beinhaltet N Einwegeschalter, welche unabhängig voneinander gesteuert werden können. Jeder der N Einwegeschalter befindet sich dabei in einem von N parallelen Strompfaden, welche jeweils eine Serienschaltung beinhaltend den Schalter und mindestens einen Widerstand enthalten. Dadurch kann der Gesamtwiderstand des Widerstandsmittels in kleinen Schritten linear variiert werden.

Daneben sind noch eine Vielzahl anderer Schaltungen zum Einstellen diskreter Widerstandswerte denkbar.

In einer vorteilhaften Ausgestaltung des Ableitungsmittels weist dieses zwei unabhängige Kanäle auf. Jeder Kanal weist einen Frequenzteiler auf, der das jeweilige Eingangssignal (das Rückkoppelsignal des Oszillatorschaltkreises, sowie das Referenzsignal) entgegennimmt. Beide Eingangssignale besitzen im Allgemeinen verschiedene Frequenzen und werden durch die beiden Frequenzteiler in zwei Ausgangs- bzw. Zwischensignale mit identischer Zielfrequenz umgesetzt. Vorteilhafterweise kann dabei auf einen der beiden Frequenzteiler verzichtet werden wenn, die Zielfrequenz identisch ist mit der Frequenz desjenigen Eingangssignals, welches die geringere Frequenz aufweist. In einer weiteren vorteilhaften Ausgestaltung ist der bzw. sind die Frequenzteiler des Ableitungsmittels als Zähler ausgebildet, welche beim Erreichen eines ausgezeichneten Zählerstandes ein Ausgangssignal abgeben. Vorteilhafterweise kann der ausgezeichnete Zählerstand der Maximalwert des jeweiligen Zählers sein und das Ausgangssignal ist mit dem Überlaufsignal des Zählers identisch.

In einer weiteren vorteilhaften Ausgestaltung des Steuermittels weist dieses neben dem Widerstandsmittel ein zusätzliches Mittel zur Steuerung des Steuerstroms des Oszillatorschaltkreises auf, welches der Frequenzänderung des Oszillatorschaltkreises, in Folge einer Temperaturänderung der Frequenz-bestimmenden Bauteile, entgegenwirkt. Die Frequenz-bestimmenden Bauteile liegen dabei vornehmlich innerhalb des Oszillatorschaltkreises und seiner Ansteuerung.

Temperaturbedingte Schwankungen der Oszillatorfrequenz sind im Wesentlichen auf Schwankungen der Steuerstromstärke zurückzuführen. Eine vorteilhafte Ausgestaltung des sogenannten Temperaturausgleichsmittels ist daher vereinfacht aufgebaut und hält vornehmlich die Steuerstromstärke bei Temperaturänderungen konstant. Das Temperaturausgleichsmittel wirkt somit der Temperaturabhängigkeit des Widerstandsmittels entgegen bzw. gleicht diese Temperaturabhängigkeit aus.

Es ist weiterhin vorteilhaft, das Temperaturausgleichsmittel als sogenannte PTAT-Quelle (Proportional To Absolute Temperature) auszubilden. Eine PTAT-Quelle besitzt einzelne Charakteristika, die sich proportional zur absoluten Temperatur ändern. In dieser vorteilhaften Ausgestaltung steigt dadurch der Anteil des Steuerstromes, der durch das Temperaturausgleichsmittel gesteuert wird, mit steigender Temperatur an, während der Anteil des Steuerstroms, der durch das Widerstandsmittel gesteuert wird, mit zunehmender Temperatur sinkt. In Summe bleibt somit der Steuerstrom konstant gegenüber Temperaturschwankungen und damit auch weitestgehend die Frequenz des Oszillatorschaltkreises.

Vorteilhafterweise besitzt dabei das Widerstandsmittel einen möglichst einfachen bzw. leicht zu kompensierenden Temperaturgang. Dies kann dadurch erreicht werden, dass das Widerstandsmittel aus einer möglichst geringen Anzahl von verschiedenen Bauteilgattungen besteht und diese in möglichst einfacher Weise verschaltet sind (z.B. Verzicht auf Kaskaden). Wie oben besprochen, enthält das Widerstandsmittel in einer besonders bevorzugten Ausführungsform identische, parallele Strompfade, wobei die Strompfade jeweils eine Serienschaltung aus einem Schalter und einem Widerstand umfassen.

Durch die Verwendung eines Temperaturausgleichsmittels wird die Frequenzkonstanz wesentlich verbessert. Besonders vorteilhaft ist dabei die kontinuierliche Korrektur der Oszillatorfrequenz, wodurch der Zeitraum zwischen zwei Kalibrierungszyklen erhöht werden kann. Dadurch reduziert sich die Anzahl der in einem bestimmten Zeitraum notwendigen Kalibrierungszyklen, was sich in einer insgesamt verringerten Leistungsaufnahme widerspiegelt.

Das erfindungsgemäße Verfahren zur Frequenzstabilisierung eines stromgesteuerten Oszillatorschaltkreises beinhaltet die Kalibrierung des stromgesteuerten Oszillatorschaltkreises mit einem Referenzsignal. Dazu werden zuerst die beiden Frequenzen verglichen, d.h. es wird die Abweichung der Frequenz des Oszillatorschaltkreises von einer Sollfrequenz bestimmt. Aus dieser Abweichung wird eine Steuergröße ermittelt, mit deren Hilfe ein Widerstandsmittel gesteuert wird, welches den Steuerstrom des Oszillatorschaltkreises und somit dessen Frequenz anpasst.

Zur Frequenzstabilisierung des stromgesteuerten Oszillatorschaltkreises beinhaltet der zur Kalibrierung notwendige Vergleich der beiden Eingangsfrequenzen folgende Unterschritte: Ableiten je eines Zwischensignals aus dem Rückkoppelsignal des Oszillatorschaltkreises sowie aus dem Referenzsignal, wobei beide Zwischensignale eine identische Zielfrequenz besitzen; Ermitteln eines Steuersignals anhand der Frequenzabweichung der beiden Zwischensignale, welches die notwendige Frequenzänderung des Oszillatorschaltkreises beschreibt; und Einstellen des steuerbaren Widerstandsmittels nach Maßgabe des Steuersignals. Vorteilhafterweise wird das Steuersignal vor dem Einstellen des steuerbaren Widerstandsmittels gefiltert, um Oszillationen des Steuersignals während des beschriebenen Kalibriervorgangs zu unterdrücken. Das Filtern kann weiterhin dazu eingesetzt werden, das Ende des Kalibriervorgangs zu bestimmen, also festzulegen, wann der Abgleich des Oszillatorschaltkreises mit dem Referenzsignal eine ausreichende Güte erreicht hat. Dies wird beispielsweise anhand einer charakteristischen Folge von Steuersignalen festgestellt.

In einer vorteilhaften Ausgestaltung des erfindungsgemäßen Verfahrens werden die temperaturbedingten Änderungen der Charakteristika der Frequenz-bestimmenden Bauteile des Oszillatorschaltkreises und seiner Ansteuerung über eine angepasste Stärke des Steuerstromes kompensiert.

In einer bevorzugten Ausgestaltung des erfindungsgemäßen Verfahrens wird der Steuerstrom bei Temperaturänderungen konstant gehalten, womit vor Allem der temperaturbedingten Änderung des Widerstandes des Widerstandsmittels begegnet wird.

In einer bevorzugten Ausgestaltung des erfindungsgemäßen Verfahrens wird die Kalibrierung des Oszillatorschaltkreises mit einem Referenzsignal nur innerhalb abgegrenzter Zeitabschnitte durchgeführt. Die Kompensation der Temperaturabhängigkeit der Frequenz-bestimmenden Bauteile des Oszillatorschaltkreises und seiner Ansteuerung wird kontinuierlich durchgeführt. Die Zeitabschnitte, während denen die Kalibrierung des Oszillatorschaltkreises mit einem Referenzsignal erfolgt, ist durch eine erhöhte Leistungsaufnahme der erfindungsgemäßen Vorrichtung gekennzeichnet. Wird die Kalibrierung nur in abgegrenzten Zeitabschnitten durchgeführt, so sinkt die im Durchschnitt aufgenommene Leistung. Durch die kontinuierliche Kompensation der Temperaturabhängigkeit der Frequenz-bestimmenden Bauteile des Oszillatorschaltkreises und seiner Ansteuerung kann der zeitliche Abstand zwischen zwei Zeitabschnitten, während welchen die Kalibrierung des Oszillatorschaltkreises mit einem Referenzsignal erfolgt, erhöht werden, wodurch die durchschnittliche Leistungsaufnahme der erfindungsgemäßen Vorrichtung weiter sinkt.

In einer vorteilhaften Ausgestaltung des erfindungsgemäßen Verfahrens zur Frequenzstabilisierung eines stromgesteuerten Oszillatorschaltkreises beinhaltet der zur Kalibrierung notwendige Vergleich der beiden Eingangsfrequenzen folgende Unterschritte. In einem ersten Schritt werden von den beiden Eingangssignalen zwei unabhängige Ausgangssignale mit identischer Zielfrequenz abgeleitet. Zu einem bestimmten Zeitpunkt können die zwei Signale, die jeweils eine Periode des jeweiligen Zwischensignals repräsentieren, zu einem sogenannten Signalpaar zusammengefasst werden. Die beiden Signale des Signalpaares haben im Allgemeinen einen gewissen zeitlichen Versatz, die sogenannte Phase des Signalpaares. Die Phase eines Signalpaares wird beispielsweise durch Zählen der Pulse eines hochfrequenten Signals bestimmt. Das Eingangssignal mit der höheren Frequenz kann dazu genutzt werden. Für das darauffolgende Signalpaar wird die Phasenbestimmung wiederholt. Daraus wird die Phasendifferenz zweier Signalpaare bestimmt. Anhand der Phasendifferenz und der zwischen den beiden Signalpaaren verstrichenen Zeit kann auf die notwendige Frequenzänderung des Oszillatorschaltkreises rückgeschlossen werden.

Das erfindungsgemäße Verfahren zur Frequenzstabilisierung eines stromgesteuerten Oszillatorschaltkreises kann beispielsweise in einem Verfahren zur Erzeugung eines Zeittaktes eingesetzt werden. Es sind jedoch noch weitere Verwendungen denkbar.

Die oben besprochenen vorteilhaften Ausgestaltungen der erfindungsgemäßen Vorrichtung und des erfindungsgemäßen Verfahrens sind nicht voneinander getrennt zu betrachten. Die Erfindung betrifft vielmehr jegliche Kombination und Unterkombination der oben besprochenen vorteilhaften Ausgestaltungen.

Durch die erfindungsgemäße Vorrichtung und das erfindungsgemäße Verfahren wird ein vereinfachter Aufbau einer Frequenzstabilisierung eines stromgesteuerten Oszillatorschaltkreises realisiert. Die vorteilhaften Ausgestaltungen sind gekennzeichnet durch eine verringerte Leistungsaufnahme der Vorrichtung zur Frequenzstabilisierung, sowie eine verbesserte Frequenzkonstanz des Oszillatorschaltkreises.

Nachfolgend wird anhand der Figuren ein Ausführungsbeispiel beschrieben. Es zeigen:
- Fig. 1:: einen schematischen Überblick der erfindungsgemäßen Vorrichtung;
- Fig. 2:: ein detailliertes Ausführungsbeispiel.

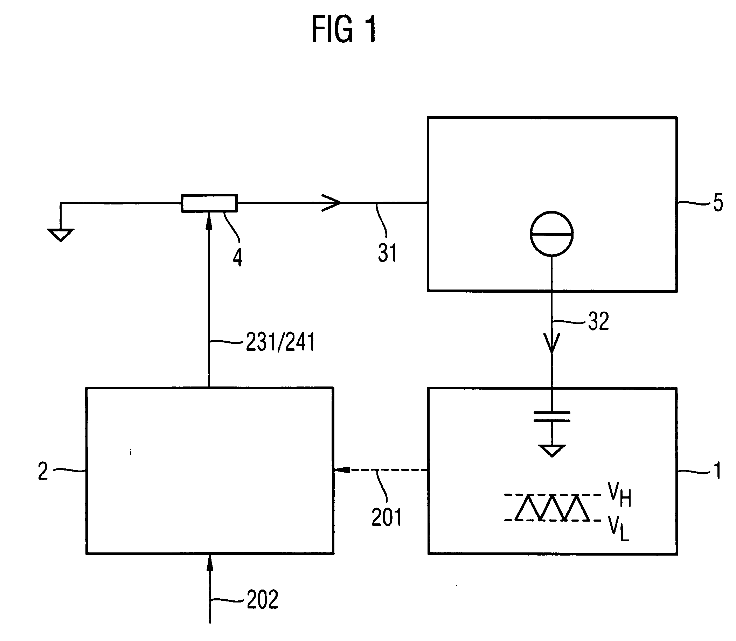

In Fig. 1 ist der stromgesteuerte Oszillatorschaltkreis 1 durch eine Kapazität und durch die schematische Darstellung des zeitlichen Spannungsverlaufs an der Kapazität 14 in Form einer Dreieckspannung angedeutet. Das Vergleichsmittel 2 erhält das Ausgangssignal 201 des Oszillatorschaltkreises 1 sowie das Referenzsignal 202. Es generiert daraus ein Steuersignal 231/241, beispielsweise in Form eines Bitwortes, zur Ansteuerung des Widerstandsmittels 4. Mit Hilfe des Widerstandsmittels 4 wird der Steuerstrom 31 gesteuert. Der frequenzangepasste Steuerstrom 31 kann mit Hilfe des Temperaturausgleichsmittels 5, das als PTAT-Quelle ausgebildet ist, zur Kompensation von Frequenzschwankungen des Oszillatorschaltkreises bedingt durch Temperaturschwankungen zusätzlich angepasst werden. Mit Hilfe des Steuerstroms 31/32 wird die Frequenz des stromgesteuerten Oszillatorschaltkreises 1 gesteuert.

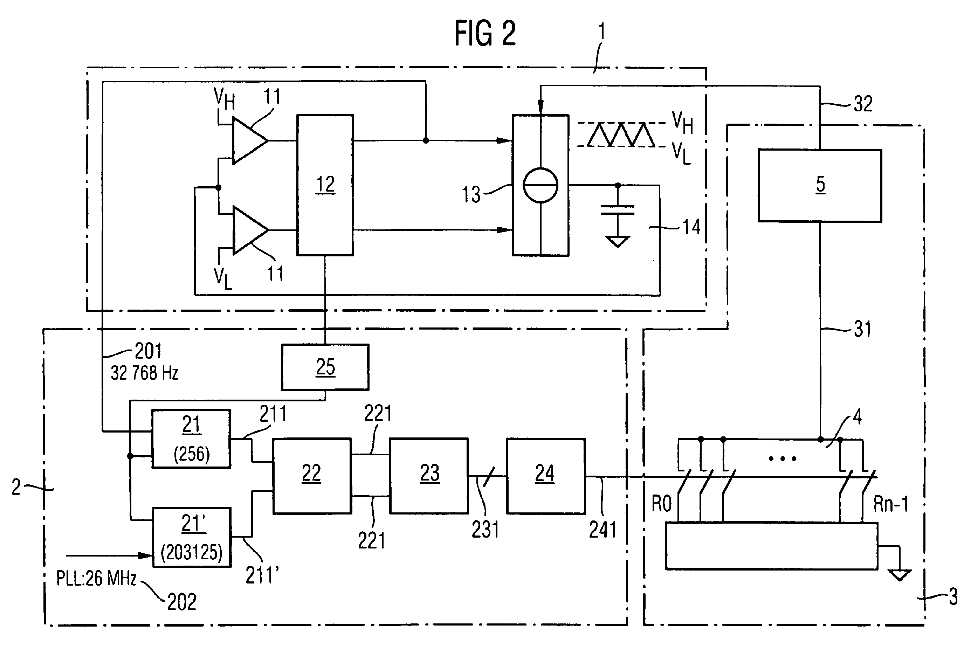

In Fig. 2 ist ein detailliertes Ausführungsbeispiel der erfindungsgemäßen Vorrichtung gezeigt. Der stromgesteuerte Oszillatorschaltkreis 1 besteht aus einem bekannten Multivibrator mit Komparatoren 11. Der Steuerstrom 32 dient zum kontrollierten Laden und Entladen der Kapazität 14 mit Hilfe des Stromumsetzers 13. Die Spannung an der Kapazität wird mit Hilfe zweier Komparatoren 11 überwacht. Die Komparatoren beziehen ihre Spannungen V_{H} bzw. V_{L} aus einer Bandlücke. Wird beispielsweise die untere Spannungsgrenze V_{L} erreicht, sendet der entsprechende Komparator ein Signal an die Kontrolleinheit 12. Diese veranlasst den Stromumsetzer 13, den Entladevorgang der Kapazität 14 zu beenden und den Aufladevorgang zu beginnen. Entsprechendes geschieht beim Erreichen der oberen Spannungsgrenze V_{H}. Über die Zuleitung 201 ist somit die Ausgangsfrequenz 201 des stromgesteuerten Oszillatorschaltkreises 1 verfügbar. Im vorliegenden Ausführungsbeispiel weist die Ausgangsfrequenz des Oszillatorschaltkreises einen Sollwert von 32.768 Hz auf. Die Ausgangsfrequenz 201 des Oszillatorschaltkreises 1 wird einem Zähler 21 zugeleitet. Dieser Zähler 21 zählt bis 256, gibt danach ein Überlaufsignal auf der Ausgangsleitung 211 aus und beginnt den Zählvorgang erneut. Auf der Ausgangsleitung 211 liegt daher ein Signal mit der Zielfrequenz 128 Hz an. Entsprechend wird dem Zähler 21' das Referenzsignal 202 mit der Frequenz 26 MHz zugeführt. Auf der Ausgangsleitung 211' liegt nach Teilung des Signals durch 203125 ebenfalls ein Signal mit der Frequenz 128 Hz an. Das Kontrollmittel 22 misst die Phase eines ersten und eines zweiten Signalpaares, wobei dazu die Pulse des hochfrequenten Referenzsignals zwischen den Signalen eines gegebenen Signalpaares gezählt werden. Aus der Differenz der beiden Phasen wird die notwendige Frequenzänderung des Oszillatorschaltkreises ermittelt. Ein entsprechendes Steuersignal wird über die Zuleitungen 221 an das Einstellmittel 23 ausgegeben. Das Einstellmittel 23 ändert das Steuersignal 231 für das Widerstandsmittel 4 entsprechend ab. Im vorliegenden Ausführungsbeispiel geschieht die Ansteuerung des Widerstandsmittels 4 über eine Mehr-Bit-Leitung 231/241. Optional kann das Bitwort auf der Mehr-Bit-Leitung 231/241 zusätzlich gefiltert werden (Filter 24), um Oszillationen der einzelnen Bitzahlen während der Kalibrierung zu vermeiden. Mit Hilfe des Bitwortes wird ein einstellbares Widerstandsmittel 4 gesteuert. In diesem

Ausführungsbeispiel besteht das Widerstandsmittel 4 aus 50 parallelen Strompfaden in denen jeweils ein Einwegeschalter und ein Einzelwiderstand in Serie geschaltet sind. Die Bauteile in jedem Strompfad sind dabei identisch. Jeder Schalter des einstellbaren Widerstandsmittels 4 wird anhand eines Bits des Bitwortes 231/241 gesteuert. Mit Hilfe des Gesamtwiderstandes des Widerstandsmittel 4 wird der Steuerstrom 31 für den Oszillatorschaltkreis bestimmt.

Der Steuerstrom 31 wird zusätzlich durch das TemperaturAusgleichsmittel 5 gesteuert, das aus einer PTAT-Quelle besteht. Durch die Verwendung einer nur minimalen Anzahl von Bauteilarten in dem Widerstandsmittel und den einfachen Aufbau der Beschaltung, kann der Temperaturgang des Widerstandsmittels gut kompensiert werden. Der Steuerstrom 32 ist daher weitgehend konstant bei Temperaturschwankungen.

## Patentansprüche

1. Vorrichtung zur Frequenzstabilisierung eines stromgesteuerten Oszillatorschaltkreises (1), enthaltend
- ein Mittel (2) zum Vergleichen der Ausgangsfrequenz des Oszillatorschaltkreises (1) mit der Frequenz eines Referenzsignals (202), und
- ein Mittel (3) zum Steuern des Steuerstroms (32) des Oszillatorschaltkreis, welches von dem Vergleichsmittel (2) angesteuert wird,
wobei das Steuermittel (3) ein Widerstandsmittel (4) mit einstellbarem Gesamtwiderstand aufweist, durch welches der Steuerstrom (32) zumindest teilweise bestimmt wird,
**dadurch gekennzeichnet, dass**
das Vergleichsmittel (2)
- ein Mittel (21,21') zum Ableiten zweier Signale (211,211') mit einer identischen Zielfrequenz aus der Ausgangsfrequenz (201) des Oszillatorschaltkreises (1) und der Frequenz des Referenzsignals (202),
- ein Kontrollmittel (22) zur Ermittlung eines Steuersignals (221) auf der Basis einer Frequenzabweichung der zwei abgeleiteten Signale (211, 211'),
- ein Einstellmittel (23) zur Einstellung des steuerbaren Widerstandsmittels (4) nach Maßgabe des Steuersignals (221) beinhaltet.

2. Vorrichtung nach Anspruch 1,
**dadurch gekennzeichnet, dass**
das Widerstandsmittel (4) durch ein Bitwort (241) ansteuerbar ist, und eine Anzahl mit Widerständen verbundener Schalter aufweist, wobei jeweils ein Schalter durch ein Bit des Bitworts (241) gesteuert wird.

3. Vorrichtung nach Anspruch 2,
**dadurch gekennzeichnet, dass**
das Widerstandmittel (4) eine Anzahl paralleler Strompfade aufweist, welche jeweils eine Serienschaltung, enthaltend einen Widerstand und einen Einwegeschalter, enthalten.

4. Vorrichtung nach einem der Ansprüche 1 bis 3,
**dadurch gekennzeichnet, dass**
das Ableitungsmittel zwei Frequenzteiler (21,21') aufweist, wobei die Frequenzteiler (21,21') beide Eingangssignale (201,202) auf zwei Ausgangssignale (211,211') mit identischer Zielfrequenz umsetzen.

5. Vorrichtung nach Anspruch 4,
**dadurch gekennzeichnet, dass**
die Frequenzteiler (21,21') des Ableitungsmittels als Zähler ausgebildet sind, die bei Erreichen eines bestimmten Zählerstandes ein Ausgangssignal (211,211') ausgegeben.

6. Vorrichtung nach einem oder mehreren der vorhergehenden Ansprüche,
**dadurch gekennzeichnet, dass**
das Steuermittel (3) ferner ein Temperaturausgleichsmittel (5) zur zusätzlichen Steuerung des Steuerstroms (32) des Oszillatorschaltkreises (1) aufweist, welches der Frequenzänderung des Oszillatorschaltkreises (1), durch die temperaturbedingten Änderungen der Charakteristika der für die Frequenz maßgeblichen Bauelemente, insbesondere der temperaturbedingten Änderung des Steuerstroms (32), entgegenwirkt und insbesondere durch eine PTAT-Quelle gebildet ist.

7. Vorrichtung zur Erzeugung eines stabilisierten Zeittaktes, enthaltend
- einen stromgesteuerten Oszillatorschaltkreis (1), sowie
- eine Vorrichtung zu dessen Frequenzstabilisierung gemäß einem oder mehrerer der vorhergehenden Ansprüche.

8. Vorrichtung nach Anspruch 7,
**dadurch gekennzeichnet, dass**
der stromgesteuerte Oszillatorschaltkreis (1) und/oder die Vorrichtung zu dessen Frequenzstabilisierung auf einem Halbleiter-Chip integriert ist.

9. Halbleiter-Chip,
der eine Vorrichtung gemäß Anspruch 8 aufweist.

10. Verfahren zur Frequenzstabilisierung eines stromgesteuerten Oszillatorschaltkreises,bei welchem der Steuerstrom (32) des Oszillatorschaltkreises (1) durch Kalibrierung des stromgesteuerten Oszillatorschaltkreises (1) mit einem Referenzsignal (202) gesteuert wird, wobei die Kalibrierung folgende Teilschritte aufweist:
a) Vergleichen der Frequenzen (201) des Oszillatorschaltkreises (1) und des Referenzsignals (202);
b) Ermitteln einer Steuergröße (241) zum Einstellen des Gesamtwiderstands eines Widerstandsmittels (4), durch welches der Steuerstrom (32) des Oszillatorschaltkreises (1) und somit dessen Frequenz angepasst wird,
**dadurch gekennzeichnet, dass**
das Vergleichen der Frequenzen (201) des Oszillatorschaltkreises (1) und des Referenzsignals (202) gemäß Teilschritt a) folgende Schritte beinhaltet:
- Ableiten zweier Signale (211,211') mit einer identischen Zielfrequenz aus der Ausgangsfrequenz (201) des Oszillatorschaltkreises (1) und der Frequenz des Referenzsignals (202),
- Ermitteln eines Steuersignals (221) auf der Basis einer Frequenzabweichung der zwei abgeleiteten Signale (211, 211'),
- Einstellen des steuerbaren Widerstandsmittels (4) nach Maßgabe des Steuersignals (221).

11. Verfahren nach Anspruch 10,
**dadurch gekennzeichnet, dass**
der Steuerstrom (32) des Oszillatorschaltkreises (1) zusätzlich in einer Art und Weise gesteuert wird, welche die Temperaturabhängigkeit der Frequenz-bestimmenden Bauteile des Oszillatorschaltkreises (1) und der Steuerung kompensiert, insbesondere wird der Steuerstrom (32) bei Temperaturänderungen konstant gehalten.

12. Verfahren nach Anspruch 10 oder 11,
**dadurch gekennzeichnet, dass**
die Kalibrierung nur innerhalb abgegrenzter Zeitabschnitte durchgeführt wird.

13. Verfahren nach Anspruch 11 oder 12,
**dadurch gekennzeichnet, dass**
die Kompensation der Temperaturabhängigkeit der Frequenz-bestimmenden Bauteile des Oszillatorschaltkreises kontinuierlich durchgeführt wird.

14. Verfahren nach einem oder mehreren der vorhergehenden Verfahrensansprüche,
**dadurch gekennzeichnet, dass** das Vergleichen der Frequenzen des Oszillatorschaltkreises (1) und des Referenzsignals (202) gemäß Teilschritt a) folgende Schritte beinhaltet:
- Erzeugen eines ersten Signalpaares anhand des Signals des Oszillatorschaltkreises und des Referenzsignals;
- Bestimmen der Phase des Signalpaares durch Zählen der Takte eines höherfrequenten Signals zwischen den beiden Pulsen des Signalpaares;
- Erzeugen eines zweiten Signalpaares und Bestimmen der Phase des zweiten Signalpaares;
- Bestimmen der Phasendifferenz der beiden Signalpaare;
- Ermitteln einer notwendigen Frequenzänderung des Oszillatorschaltkreises anhand der Phasendifferenz;

15. Verfahren zur Erzeugung eines stabilisierten Zeittaktes, enthaltend ein Verfahren zur Frequenzstabilisierung eines stromgesteuerten Oszillatorschaltkreises (1) gemäß Anspruch 10.

## Claims

1. Device for the frequency stabilization of a current-controlled oscillator circuit (1), containing
- a means (2) for comparing the output frequency of the oscillator circuit (1) with the frequency of a reference signal (202), and
- a means (3) for controlling the control current (32) of the oscillator circuit, which is driven by the comparison means (2),
the control means (3) exhibiting a resistance means (4) with adjustable total resistance by means of which the control current (32) is at least partially determined,
**characterized in that**
the comparison means (2) contains
- a means (21, 21') for deriving two signals (211, 211') having an identical target frequency from the output frequency (201) of the oscillator circuit (1) and the frequency of the reference signal (202),
- a control means (22) for determining a control signal (221) on the basis of a frequency deviation of the two derived signals (211, 211'),
- an adjusting means (23) for adjusting the controllable resistance means (4) in dependence on the control signal (221).

2. Device according to Claim 1, **characterized in that** the resistance means (4) can be driven by a bit word (241) and has a number of switches connected to resistances, one switch in each case being controlled by one bit of the bit word (241).

3. Device according to Claim 2, **characterized in that** the resistance means (4) exhibits a number of parallel current paths which in each case contain a series circuit containing a resistance and a one-way switch.

4. Device according to one of Claims 1 to 3, **characterized in that** the derivation means exhibits two frequency dividers (21, 21'), the frequency dividers (21, 21') converting both input signals (201, 202) to two output signals (211, 211') having an identical target frequency.

5. Device according to Claim 4, **characterized in that** the frequency dividers (21, 21') of the derivation means are constructed as counters which output an output signal (211, 211') when a certain count is reached.

6. Device according to one or more of the preceding claims, **characterized in that** the control means (3) also exhibits a temperature compensation means (5) for additionally controlling the control current (32) of the oscillator circuit (1), which counteracts the frequency change of the oscillator circuit (1) due to the temperature-related changes in the characteristics of the components decisive for the frequency, particularly the temperature-related change in the control current (32) and, in particular, is formed by a PTAT source.

7. Device for generating a stabilized timing clock, containing
- a current-controlled oscillator circuit (1), and
- a device for stabilizing its frequency according to one or more of the preceding claims.

8. Device according to Claim 7, **characterized in that** the current-controlled oscillator circuit (1) and/or the device for stabilizing its frequency is integrated on a semiconductor chip.

9. Semiconductor chip which exhibits a device according to Claim 8.

10. Method for the frequency stabilization of a current-controlled oscillator circuit in which the control current (32) of the oscillator circuit (1) is controlled by calibration of the current-controlled oscillator circuit (1) by means of a reference signal (202), the calibration exhibiting the following substeps:
a) comparing the frequencies (201) of the oscillator circuit (1) and of the reference signal (202);
b) determining a control variable (241) for adjusting the total resistance of a resistance means (4), by means of which the control current (32) of the oscillator circuit (1), and thus its frequency, is adapted, and
**characterized in that** the comparing of the frequencies (201) of the oscillator circuit (1) and of the reference signal (202) according to substep a) contains the following steps:
- deriving two signals (211, 211') having an identical target frequency from the output frequency (201) of the oscillator circuit (1) and from the frequency of the reference signal (202),
- determining a control signal (221) on the basis of a frequency deviation of the two derived signals (211, 211'),
- adjusting the controllable resistance means (4) in dependence on the control signal (221).

11. Method according to Claim 10, **characterized in that** the control current (32) of the oscillator circuit (1) is additionally controlled in a manner which compensates for the temperature-dependence of the frequency-determining components of the oscillator circuit (1) and of the control arrangement, particularly, the control current (32) is kept constant with temperature changes.

12. Method according to Claim 10 or 11, **characterized in that** the calibration is only performed within delimited time intervals.

13. Method according to Claim 11 or 12, **characterized in that** the compensation of the temperature dependence of the frequency-determining components of the oscillator circuit is performed continuously.

14. Method according to one or more of the preceding method claims, **characterized in that** the comparing of the frequencies of the oscillator circuit (1) and of the reference signal (202) according to substep a) contains the following steps:
- generating a first signal pair by means of the signal of the oscillator circuit and of the reference signal;
- determining the phase of the signal pair by counting the clock cycles of a higher-frequency signal between the two pulses of the signal pair;
- generating a second signal pair and determining the phase of the second signal pair;
- determining the phase difference of the two signal pairs;
- determining a necessary frequency change of the oscillator circuit by means of the phase difference.

15. Method for generating a stabilized timing clock, containing a method for the frequency stabilization of a current-controlled oscillator circuit (1) according to Claim 10.

## Revendications

1. Dispositif de stabilisation de fréquence d'un circuit (1) d'oscillateur commandé par le courant, comprenant
- un moyen (2) de comparaison de la fréquence de sortie du circuit (1) d'oscillateur à la fréquence d'un signal (202) de référence, et
- un moyen (3) de commande du courant (32) de commande du circuit d'oscillateur, qui est commandé par le moyen (2) de comparaison,
le moyen (3) de commande ayant un moyen (4) à résistance totale réglable par laquelle le courant (32) de commande est déterminé au moins en partie,
**caractérisé en ce que**
le moyen (2) de comparaison comporte
- un moyen (21, 21') de dérivation de deux signaux (211, 211') ayant une fréquence cible identique à partir de la fréquence (201) de sortie du circuit (1) d'oscillateur et de la fréquence du signal (202) de référence,
- un moyen (22) de contrôle pour déterminer un signal (221) de commande sur la base d'un écart de fréquence entre les deux signaux (211, 211') dérivés,
- un moyen (23) de réglage pour régler, en fonction du signal (221) de commande, le moyen (4) à résistance pouvant être commandé.

2. Dispositif suivant la revendication 1,
**caractérisé en ce que** le moyen (4) à résistance peut être commandé par un mot (241) binaire et a un certain nombre d'interrupteurs reliés aux résistances, un interrupteur respectif étant commandé par un bit du mot (241) binaire.

3. Dispositif suivant la revendication 2,
**caractérisé en ce que** le moyen (4) à résistance a un certain nombre de trajets de courant parallèles, qui comportent respectivement un circuit série comportant une résistance et un interrupteur à sens unique.

4. Dispositif suivant l'une des revendications 1 à 3,
**caractérisé en ce que** le moyen de dérivation comporte deux diviseurs (21, 21') de fréquence, les diviseurs (21, 21') de fréquence transformant deux signaux (201, 202) d'entrée en deux signaux (211, 211') de sortie de fréquence cible identique.

5. Dispositif suivant la revendication 4,
**caractérisé en ce que** les diviseurs (21, 21') de fréquence des moyens de dérivation sont constitués en compteur qui, lorsque le compteur atteint un certain état, émet un signal (211, 211') de sortie.

6. Dispositif suivant l'une ou plusieurs des revendications précédentes,
**caractérisé en ce que** le moyen (3) de commande comprend en outre un moyen (5) de compensation de la température pour commander supplémentairement le courant (32) de commande du circuit (1) d'oscillateur qui s'oppose à la variation de fréquence du circuit (1) d'oscillateur par les modifications dues à la température des caractéristiques des composants déterminants pour la fréquence, notamment à la variation due à la température du courant (32) de commande, et qui est formé notamment par une source PTAT.

7. Dispositif de production d'un cadencement stabilisé, comprenant
- un circuit (1) d'oscillateur commandé par le courant, ainsi que
- un dispositif pour sa stabilisation de fréquence suivant l'une ou plusieurs des revendications précédentes.

8. Dispositif suivant la revendication 7,
**caractérisé en ce que** le circuit (1) d'oscillateur commandé par le courant et/ou le dispositif pour la stabilisation de sa fréquence est intégré à une puce à semi-conducteur.

9. Puce à semi-conducteur qui a un dispositif suivant la revendication 8.

10. Procédé de stabilisation de la fréquence d'un circuit d'oscillateur commandé par le courant, dans lequel le courant (32) de commande du circuit (1) d'oscillateur est commandé par étalonnage du circuit (1) d'oscillateur commandé par le courant par un signal (202) de référence, l'étalonnage ayant les sous-stades suivants :
a) comparaison des fréquences (201) du circuit (1) d'oscillateur et du signal (202) de référence ;
b) détermination d'une grandeur (241) de commande pour régler la résistance totale d'un moyen (4) à résistance par lequel le courant (32) de commande du circuit (1) d'oscillateur et ainsi sa fréquence sont adaptés,
**caractérisé en ce que**
la comparaison des fréquences (201) du circuit (1) d'oscillateur et du signal (202) de référence suivant le sous-stade a) comporte les stades suivants :
- dérivation de deux signaux (211, 211'), ayant une fréquence cible identique, de la fréquence (201) de sortie du circuit (1) d'oscillateur et de la fréquence du signal (202) de référence,
- détermination d'un signal (221) de commande sur la base d'un écart de fréquence entre les deux signaux (211, 211') dérivés,
- réglage du moyen (4) à résistance pouvant être commandé en fonction du signal (221) de commande.

11. Procédé suivant la revendication 10,
**caractérisé en ce que** le courant (32) de commande du circuit (1) d'oscillateur est commandé en outre d'une façon qui compense la variation en fonction de la température des composants déterminant la fréquence du circuit (1) d'oscillateur et de la commande, notamment en maintenant constant le courant (32) de commande lorsqu'il se produit des modifications de température.

12. Procédé suivant la revendication 10 ou 11,
**caractérisé en ce que** l'on effectue l'étalonnage seulement dans des laps de temps limités.

13. Procédé suivant la revendication 11 ou 12,
**caractérisé en ce que** l'on effectue d'une manière continue la compensation de la variation en fonction de la température des composants déterminant la fréquence du circuit d'oscillateur.

14. Procédé suivant l'une ou plusieurs des revendications de procédé précédentes,
**caractérisé en ce que**
la comparaison des fréquences du circuit (1) d'oscillateur et du signal (202) de référence suivant le sous-stade a) comprend les stades suivants :
- production d'une paire de signaux au moyen du signal du circuit d'oscillateur et du signal de référence ;
- détermination de la phase de la paire de signaux en comptant les cadencements d'un signal de fréquence plus haute entre les deux impulsions de la paire de signaux ;
- production d'une deuxième paire de signaux et détermination de la phase de la deuxième paire de signaux ;
- détermination de la différence de phase entre les deux paires de signaux ;
- détermination d'une variation de fréquence nécessaire du circuit d'oscillateur au moyen de la différence de phase.

15. Procédé de production d'un cadencement stabilisé, comportant un procédé de stabilisation de la fréquence d'un circuit (1) d'oscillateur commandé par le courant suivant la revendication 10.
